(19) Europäisches Patentamt / European Patent Office / Office européen des brevets

(11) **EP 2 106 465 B1**

(12) **EUROPÄISCHE PATENTSCHRIFT**

(45) Veröffentlichungstag und Bekanntmachung des Hinweises auf die Patenterteilung:
**06.03.2013   Patentblatt 2013/10**

(51) Int Cl.:
*C30B 29/42* *(2006.01)*      *C30B 11/00* *(2006.01)*

(21) Anmeldenummer: **08759007.1**

(22) Anmeldetag: **04.06.2008**

(86) Internationale Anmeldenummer:
**PCT/EP2008/004450**

(87) Internationale Veröffentlichungsnummer:
**WO 2008/148542 (11.12.2008 Gazette 2008/50)**

(54) **ANORDNUNG UND VERFAHREN ZUR HERSTELLUNG EINES KRISTALLS AUS DER SCHMELZE EINES ROHMATERIALS**

ARRANGEMENT AND METHOD FOR PRODUCING A CRYSTAL FROM THE MELT OF A RAW MATERIAL

DISPOSITIF ET PROCÉDÉ DE FABRICATION D'UN CRISTAL À PARTIR D'UNE MASSE EN FUSION D'UNE MATIÈRE PREMIÈRE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **06.06.2007   DE 102007026298**
**06.06.2007   US 942298 P**

(43) Veröffentlichungstag der Anmeldung:
**07.10.2009   Patentblatt 2009/41**

(60) Teilanmeldung:
**12155975.1 / 2 458 041**

(73) Patentinhaber: **Freiberger Compound Materials GmbH**
**09599 Freiberg (DE)**

(72) Erfinder:
• **EICHLER, Stefan**
**01187 Dresden (DE)**
• **BÜNGER, Thomas**
**21335 Lüneburg (DE)**
• **BUTTER, Michael**
**09599 Freiberg (DE)**
• **RÜHMANN, Rico**
**09544 Neuhausen (DE)**
• **SCHEFFER-CZYGAN, Max**
**09116 Chemnitz (DE)**

(74) Vertreter: **Prüfer & Partner GbR**
**European Patent Attorneys**
**Sohnckestrasse 12**
**81479 München (DE)**

(56) Entgegenhaltungen:
**EP-A- 0 130 865      WO-A-2005/041278**
**DE-A1- 10 239 104    DE-A1- 19 704 075**
**DE-A1- 19 912 484    GB-A- 2 218 789**
**JP-A- 10 338 592     US-A- 3 796 552**
**US-A- 4 840 699      US-A1- 2007 012 242**

• HAGI Y ET AL: "Low dislocation density 3-inch Si doped GaAs crystals by Vertical Boat growth" SEMICONDUCTING AND SEMI-INSULATING MATERIALS CONFERENCE, 1996. IEEE TOULOUSE, FRANCE 29 APRIL-3 MAY 1996, NEW YORK, NY, USA,IEEE, US, 29. April 1996 (1996-04-29), Seiten 279-282, XP010213077 ISBN: 978-0-7803-3179-2
• HASHIO K ET AL: "SIX-INCH-DIAMETER SEMI-INSULATING GAAS CRYSTAL GROWN BY THE VERTICAL BOAT METHOD" COMPOUND SEMICONDUCTORS 1998. PROCEEDINGS OF THE 25TH INTERNATIONAL SYMPOSIUM ON COMPOUND SEMICONDUCTORS. NARA, JAPAN, OCT. 12 - 16, 1998; [INSTITUTE OF PHYSICS CONFERENCE SERIES], LONDON : IOP, GB, Bd. NR. 162, Nr. 162, 12. Oktober 1998 (1998-10-12), Seiten 523-528, XP000895293 ISBN: 978-0-7503-0611-9

**Beschreibung**

Die Erfindung betrifft eine Anordnung zum Herstellen kristalliner Materialien, insbesondere solcher mit großen Dimensionen. Insbesondere betrifft die Erfindung auch die Herstellung von Halbleitern nach dem VB-Verfahren (Vertical Bridgman), beziehungsweise dem VGF-Verfahren (Vertical Gradient Freeze).

Die Wirtschaftlichkeit bei der Herstellung von Kristallen wird wesentlich vom Durchsatz, d.h. kristallisierte Masse pro Zeiteinheit) des Materials durch die Kristallisationsöfen und vom dazu notwendigen Energieverbrauch bestimmt. Viele ein- oder polykristalline Materialien werden aus der Schmelze in einem Temperaturfeld gerichtet erstarrt. Solche Verfahren werden Gradient-Freeze- (gerichtete Erstarrung) oder Bridgman-Verfahren genannt, siehe auch Wilke, K.-Th. and J. Bohm in: "Kristallzüchtung", Ed. K.-Th. Wilke., 1. Auflage ed. VEB Deutscher Verlag der Wissenschaften, 1973, 1-922.

Für viele Materialeigenschaften des zu fertigenden Kristalls wie etwa der Dotierstoffeinbau, die strukturelle Perfektion oder die elastische Verspannung ist es besonders wichtig, dass die Kristallisationsfront im Tiegel während der Erstarrung keine oder nur geringe Krümmungen aufweist. Um Krümmungen der Phasengrenzen vermeiden zu können, muss in allen Punkten einer zur Erstarrungsrichtung senkrechten Richtung gleichermaßen die axiale Wärmeflussbedingung eingehalten werden:

$$v = \left(q_{Schmelze} - q_{Kristall}\right)/\Delta h_{latent}\rho_{Kristall} \cdot$$

Dabei bezeichnet v die axiale Kristallisationsgeschwindigkeit, q die axialen Wärmeflüsse jeweils in Schmelze und Kristall an der Kristallisationsfront, $\Delta h_{latent}$ die spezifische latente Wärme des Phasenübergangs und $\rho_{Kristall}$ die Massendichte des erstarrten Materials. Der Wärmefluss im Kristall berechnet sich als Produkt von Wärmeleitfähigkeit $\lambda$ und Temperaturgradient grad(T). Näherungsweise kann auch $\Delta T/\Delta x$ angegeben werden, wenn x die axiale Koordinate in Erstarrungsrichtung ist. Mit der Näherung eines verschwindenden Wärmeflusses in der Schmelze, $q_{Schmelze} = 0$, ergibt sich für die Wachstumsgeschwindigkeit eine obere Grenze:

$$v \le \left(\lambda/\Delta h_{latent}\rho_{Kristall}\right) \cdot grad(T).$$

Der Temperaturgradient kann allerdings für viele Materialien wegen der auftretenden thermoelastischen Spannungen nicht beliebig groß gewählt werden. Insbesondere für länger werdende Kristalle wird dann die Wachstumsgeschwindigkeit notwendig kleiner. In diesem Fall wird der Wärmewiderstand des Kristalls mit fortschreitender Kristallisation immer größer und die ableitbare latente Leistung, d.h. die latente Wärme pro Zeiteinheit, nimmt ab. Dies begrenzt wiederum auch die Wachstumsgeschwindigkeit für lange Kristalle.

Aus ökonomischen Gründen insbesondere auch des Materialdurchsatzes in Kristallisationsöfen ist es folglich wenig sinnvoll, die Kristalllänge über bestimmte materialabhängige Grenzen zu erhöhen. Der Materialdurchsatz könnte dagegen durch die Vergrößerung der Fläche, auf der das Material gleichzeitig kristallisiert, erhöht werden. Dabei wird die latente Leistung proportional zur Kristallisationsfläche größer, jedoch erhöht sich auch die Wärmeableitung von der Phasengrenze flächenproportional.

Oft werden für die Weiterverarbeitung des kristallinen Materials zu elektronischen Bauelementen oder integrierten Schaltkreisen, Solarzellen, optischen Bauelementen usw. auch nur bestimmte standardisierte Materialgrößen benötigt. Eine beliebige Vergrößerung der Kristallisationsfläche im Tiegel kommt daher aus Gründen einer fehlenden entsprechenden Nachfrage nicht ohne weiteres in Betracht.

Es ist bekannt, nicht einen größeren Materialblock zu kristallisieren, sondern jeweils parallel zueinander mehrere formangepasste dünnere Kristalle herzustellen. Solche Bridgman-artigen Methoden sind für optische Materialien wie Seltenenerde-Fluoride gemäß der US 3,796,552 A oder für Szintillatorkristalle wie Bariumfluorid gemäß der EP 0,130,865 A1 bekannt. Hier liegen jedoch kleine Verhältnisse der Durchmesser zu den jeweiligen Längen der Kristalle vor.

Für im Vergleich dazu größere Kristalle, die in mikro- und opto-elektronischen, photovoltaische oder optischen Anwendungen Platz finden sollen, sind entsprechende Lösungen bisher nicht angestrebt worden. Die große Herausforderung liegt nämlich darin, das Temperaturfeld zu jedem Zeitpunkt der Kristallisation so zu auszubilden, dass wichtige Eigenschaften wie z.B. der elektrische Widerstand, die Ladungsträgerbeweglichkeit, die Punktdefektkonzentrationen, die strukturelle Perfektion, elastische Spannungen, der optische Brechungsindex, die Reflektivität usw. bezüglich der Homogenität quer durch den Kristall den Zielvorgaben der Hersteller jeweiliger Anwendungen entsprechen.

Für Halbleiterkristalle, die im weiteren Fertigungsprozess zu Halbleiterwafern verarbeitet werden, spielt die radiale Homogenität eine für die Bauelementeprozessierung besonders wichtige Rolle. So sollen Parameter wie der spezifische elektrische Widerstand, die Ladungsträgerbeweglichkeit, Dotierstoff- bzw. Fremdstoffkonzentration, oder die Restspannung besonders homogen über den Wafer verteilt sein.

Hinsichtlich einkristalliner Materialien bestehen weiter erhöhte Anforderungen darin, die genaue Kristallorientierung zu berücksichtigen. Meist wird hier ein Keimkristall vorgelegt werden, der die Kristallrichtung des zu wachsenden Kristalls festlegt. Verfahren, bei denen der Einkristall durch spontane Keimbildung und nachfolgender Keimauswahl erzeugt wird, scheiden aus materialökonomischen Gründen oftmals aus.

Die Schwierigkeit des Ankeimens an einen Keimkristall besteht darin, das Temperaturfeld derart auszubilden, dass das aufgeschmolzene Material den Keim berührt und der Keim dann leicht zurückgeschmolzen wird. Für Bridgman- oder Gradient-Freeze-Verfahren ist es üblich, die Anordnung der Wärmequellen und -senken so zu wählen, dass das gewünschte Temperaturfeld erzeugt werden kann. Bei zunehmend großen Aufbauten wird es nun zusätzlich notwendig, so genannte Liner mit entsprechenden thermischen Eigenschaften derart anzuordnen, dass ein Temperaturfeld auch über größere Gebiete hin geformt werden kann, wie es etwa in den Druckschriften EP 1,147,248 und US 6,712,904 beschrieben ist.

Der Erfindung liegt folglich unter anderem eine Aufgabe zugrunde, die Wirtschaftlichkeit der Kristallherstellung zu verbessern, insbesondere den Materialdurchsatz in Kristallisationsöfen zu erhöhen.

Ferner liegt ihr die Aufgabe zugrunde, die Qualität der hergestellten Kristalle hinsichtlich der Homogenität der für die jeweiligen Anwendungen insbesondere im mikro- und opto-elektronischen Bereich wichtigen Eigenschaften zu verbessern.

Diese und weitere Aufgaben werden gelöst durch eine Anordnung gemöβ Anspruch 1 oder Anspruch 11 zur Herstellung eines Kristalls aus der Schmelze eines Rohmaterials, umfassend:

> einen Ofen mit einer ein oder mehrere Heizelemente aufweisenden Heizvorrichtung, die zur Erzeugung eines in einer ersten Richtung gerichteten Temperaturfeldes in dem Ofen eingerichtet ist,
> eine Vielzahl von wenigstens zwei, vorzugsweise drei oder mehr Tiegeln zur Aufnahme der Schmelze, die nebeneinander in dem gerichteten Temperaturfeld angeordnet sind, und
> eine Einrichtung zur Homogenisierung des Temperaturfelds in einer Ebene senkrecht zu der ersten Richtung in den Tiegeln, bei der es sich um in Zwischenräume zwischen den Tiegeln einzubringendes Füllmaterial mit anisotroper Wärmeleitfähigkeit oder auch um ein Gerät zu Erzeugung magnetischer Wanderfelder oder um eine Kombination aus beiden handeln kann.

Beide Einrichtungen ergänzen einander in Kombination besonders gut, wenn sehr lange Kristalle herzustellen sind. In axialer Richtung kann nämlich die Einflussnahme durch anisotrope Füllmaterialien auf kürzere Reichweiten begrenzt sein, während magnetische Wanderfelder Abweichungen über größere Reichweiten kompensieren können. Die erreichbare Homogenität kann somit zu höheren Kristalllängen hin verschoben werden.

Ferner sind aber auch alle weiteren in der beigefügten Beschreibung, den Figuren oder in den beigefügten Ansprüchen dargestellten Merkmale im Einzelnen zusammen mit dem Gerät zur Erzeugung magnetischer Wanderfelder einsetzbar, d.h., insbesondere auch ohne die Einschränkung, dass dabei ein Füllmaterial mit anisotroper Wärmeleitung verwendet wird.

Die Erfindung sieht vor, beispielsweise mehrere Tiegel nebeneinander in einem Ofen anzuordnen und diese - angefüllt mit der Schmelze - gemeinsam einem gerichteten Temperaturfeld auszusetzen. Die Homogenität von Eigenschaften wie etwa der spezifische elektrische Widerstand, Verunreinigungsgrad, Korngrößen, Restspannungen etc. der wachsenden Kristalle in der Anordnung stehender Tiegel wird dabei grundsätzlich in Mitleidenschaft gezogen, weil gefunden wurde, dass sich eine (azimuthale) Asymmetrie aufgrund der jeweils aufeinander gerichteten gegenseitigen Wärmeleitung und -strahlung ergibt.

Hier setzt die Erfindung an, indem eine Vorrichtung vorgeschlagen wird, die gerade diese Inhomogenitäten kompensiert, d.h. die Störungen in der Rotationssymmetrie des den jeweiligen Tiegel umgebenden Temperaturfelds aufhebt.

Als Füllmaterial kommen bei der Erfindung auch mit der gleichen Rohschmelze wie in den Tiegeln gefüllte Zwischentiegel in Betracht. In diesem Fall tritt nämlich aufgrund des Temperaturgefälles in axialer Richtung gleichermaßen wie bei der Rohschmelze des herzustellenden Einkristalls eine Kristallisationsfront mit der Folge auf, dass die Wärmeleitung in genau dieser Richtung aufgrund der Änderung des Materialzustands ebenfalls anisotrop wird.

Gemäß der vorliegenden Erfindung ist ferner ein Verfahren zur Herstellung eines kristallinen Materials aus der Schmelze eines Rohmaterials gemäß Anspruch 16 vorgesehen.

Die Anordnunger und Verfahren der Erfindung sind außerdem auf einen Kristall gerichtet, der gemäß einer Weiterbildung als ein Halbleitermaterial vorzugsweise GaAs umfassen kann und eine Verteilung der Versetzungsdichte aufweist und bei dem eine globale Standardabweichung ($\sigma_{global}$) einer die Versetzungsdichte repräsentierenden Ätzgrubendichte (epd) in einer Ebene senkrecht zur Längsachse des Einkristalls weniger als 23 % von einem mittleren Wert der Ätzgrubendichte für den Einkristall beträgt, wobei der Bestimmung globalen Standardabweichung eine charakteristische Länge von 5 mm zugrunde liegt. Es handelt sich dabei um Wertebereiche für Standardabweichungen von Eigenschaften, die charakteristisch für die erfindungsgemäß hergestellten kristallinen Materialien sind.

Ein anderer hier vorgeschlagener Kristall (wie oben beispielsweise GaAs) umfasst eine Verteilung des spezifischen elektrischen Widerstands aufweist. Bei dem Einkristall beträgt eine globale Standardabweichung ($\sigma_{global}$) in einer Ebene senkrecht zur Längsachse des Einkristalls weniger als 5.3 % von einem mittleren Wert des spezifischen elektrischen Widerstands für den Einkristall, wobei der Bestimmung lokalen Standardabweichung eine charakteristische Länge von 10 mm zugrunde liegt.

Der Kristall kann insbesondere auch ein Einkristall sein, polykristallines Material ist aber nicht ausgeschlossen.

Es ist anzumerken, dass die hier vorgeschlagene Anordnung unter anderem auch zur Durchführung der Kristallisation nach dem VGF-Verfahren oder alternativ auch zur Durchführung nach dem VB-Verfahren eingerichtet sein kann.

Weitere vorteilhafte Ausgestaltungen der Erfindung sind den abhängigen Ansprüchen zu entnehmen.

Die Erfindung soll nun anhand von Ausführungsbeispielen mit Hilfe einer Zeichnung näher erläutert werden. Darin zeigen:

Fig. 1 : eine Anordnung mit nebeneinander positionierten Tiegeln in einem VGF-Ofen (Vertical Gradient Freeze) mit äußerem Druckkessel;

Fig. 2: eine Anordnung ähnlich Fig. 1, bei der jedoch die Tiegel jeweils in gasdichte Druckbehälter gefasst sind;

Fig. 3: eine Anordnung ähnlich Fig. 1, bei der jedoch ein VB-Ofen (Vertical Bridgman) realisiert ist;

Fig. 4: ein Querschnitt senkrecht zur Längsachse durch eine geometrisch beispielhafte Anordnung von 3 kreisrunden Tiegeln;

Fig. 5 : wie Fig. 4, jedoch mit 4 runden Tiegeln;

Fig. 6: wie Fig. 4, jedoch mit 4 quadratische Tiegeln;

Fig. 7: wie Fig. 4, jedoch mit einer konzentrischen Anordnung von 7 runden Tiegeln;

Fig. 8: wie Fig. 4, jedoch mit einer matrixartigen, hexagonalen Anordnung von 12 runden Tiegeln;

Fig. 9: wie Fig. 7, jedoch mit einem in der Mitte verkleinert ausgeführten Tiegel;

Fig. 10: wie Fig. 1, wobei für die äußeren Mantelheizer Vorrichtungen zur Erzeugung magnetischer Wanderfelder zur gezielten Bildung von Konvektion in den Tiegeln vorgesehen sind, gemäß einen ersten Ausführungsbeispiel der Erfindung; Fig. 11: wie Fig. 1, wobei zusätzlich zu den äußeren Mantelheizern in der Mitte des Ofens Vorrichtungen zur Erzeugung von magnetischen Wanderfeldern vorgesehen sind, gemäß einem zweiten Ausführungsbeispiel der Erfindung;

Fig. 12: wie Fig. 5, wobei gemäß einem dritten Ausführungsbeispiel Füllköper in die Tiegelzwischenräume eingebracht sind;

Fig. 13: wie Fig. 12, wobei die Tiegel jeweils einzeln in gasdichte Druckbehälter gefasst sind;

Fig. 14: wie Fig. 5, wobei gemäß einem vierten Ausführungsbeispiel der Erfindung Zwischentiegel in die Zwischenräume zwischen den Erstarrungstiegeln eingebracht sind;

Fig. 15: wie Fig. 14, wobei die Tiegel gemeinsam in einem Druckkessel des Ofens eingerichtet sind.

Es werden in den Ausführungsbeispielen der Erfindung Anordnungen 1 beschrieben, mit denen beispielhaft Einkristalle aus III-V-, IV-IV- und II-VI-Verbindungen wie z.B. Galliumarsenid (GaAs, Indiumphosphid (InP), Cadmiumtellurid (CdTe), Cadmiumquecksilbertellurid und verschiedene Antimonide sowie Elementhalbleiter wie Germanium (Ge) und Silizium (Si) hergestellt werden können. Außerdem können polykristalline Materialien wie z.B. Silizium (Si) für photovoltaische Anwendungen erstarrt werden.

Mehrere Tiegel 14 werden dabei nebeneinander so angeordnet, dass eine entsprechende Anzahl großer Kristalle mit Durchmessern bzw. - im Fall von rechteckigen Tiegelquerschnitten: Kantenlängen - von bis zu 125 mm oder mehr (beispielsweise zur Herstellung von 8"-Kristallen und daraus hergestellten Wafern) gleichzeitig in ein und derselben Anordnung bzw. in ein und demselben Temperaturfeld wächst, das in der Anordnung 1 erzeugt wird.

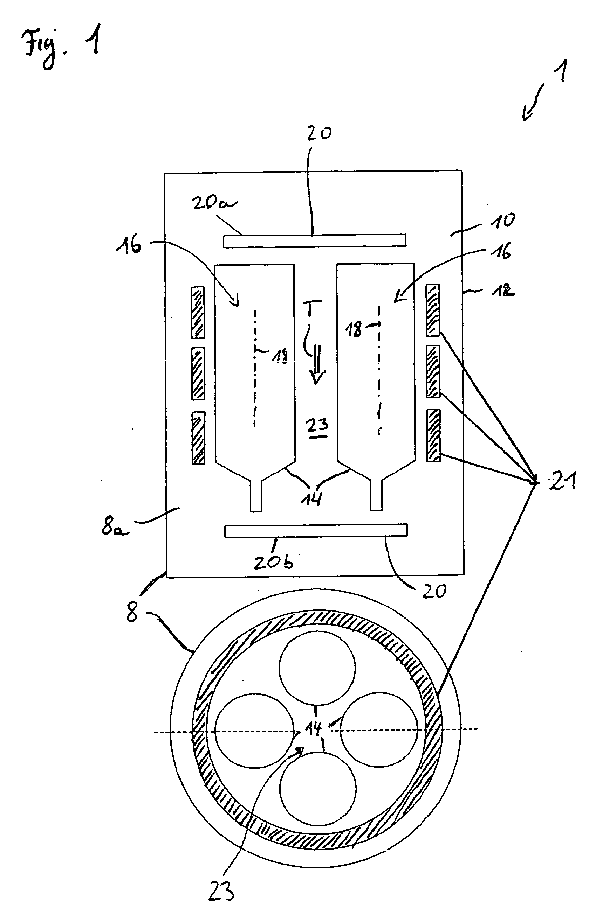

Eine mit der Erfindung zu verwendende Anordnung 1 ist im Längsschnitt (oben) und im Querschnitt (unten) in Figur 1 dargestellt. Die Schnittachse ist unten durch eine gestrichelte Linie angedeutet. Die Anordnung 1 umfasst einen VGF-Ofen 10 mit einer hier zylindrischen Ofenwand 12, in welchem mehrere Tiegel 14 angeordnet sind. Die Tiegel 14 nehmen eine Schmelze 16, beispielsweise aus Galliumarsenid auf. Durch eine Anordnung von Heizelementen 20 wird ein gerichtetes Temperaturfeld T erzeugt, das im Wesentlichen innerhalb der Zeichenblattebene in Fig. 1 zu den Längsachsen 18 der Tiegel 14 parallel steht.

Die Heizelemente 20 umfassen einen oder mehrere Deckel- 20a und Bodenheizer 20b, welche im Betrieb mit einem gegenseitigen Temperaturunterschied zur Bildung des Temperaturfelds T eingestellt werden. Die Anordnung kann ferner Mantelheizer 21 aufweisen, die einen senkrecht zum Temperaturfeld T gerichteten Wärmefluss unterbinden und generell das Temperaturniveau in einer Umgebung um den Schmelzpunkt (GaAs: etwa 1238 °C) herum halten. Sie umgeben also die Gesamtheit der Tiegel 14 als solche.

Die Tiegel 14 stehen vorzugsweise mit ihrer Längsachse 18 parallel zueinander und überlappen sich in Bezug auf eine Höhenposition in Richtung des Temperaturfelds T. Die Boden- und Deckelheizer 20a, 20b besitzen eine Ausdehnung, die ausreicht um die Gesamtheit der Tiegel zwischen sich aufzunehmen bzw. abzudecken, um insoweit eine bestmögliche Homogenität zu erzielen. Die Boden- und Deckelheizer 20a, 20b sind beispielsweise u.a. aus CFC gefertigt und besitzen hervorragende Wärmeleiteigenschaften. Z.B. beträgt die Ausdehnung der Boden- und Deckelheizer 20a, 20b das 1,5- bis 2-fache der nahe beieinander zusammengestellten Tiegel 14.

Das oben beschriebene Temperaturfeld T kann in einem wassergekühlten und bei Bedarf vakuum- und druckdichten Behälter 8 (Druckkessel) erzeugt werden, welcher in seinem Innenraum 8a die Vielzahl der Tiegel 14 aufnimmt. Die in Fig. 1 gezeigte Ofenwand 12 ist in diesem Beispiel folglich gas-, vakuum- und druckdicht.

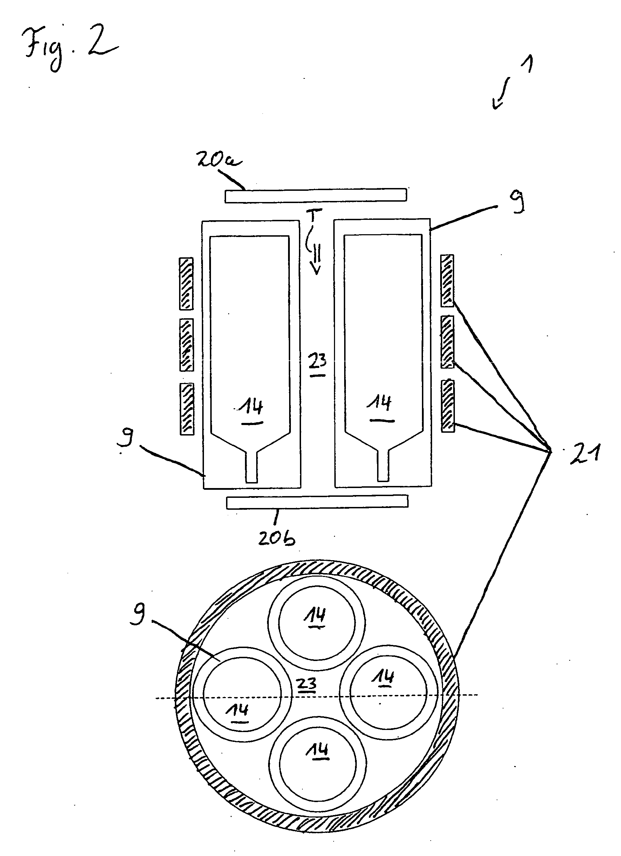

Eine alternativ im Rahmen der Erfindung zu verwendende Anordnung gemäß Fig. 2 sieht vor, insbesondere für Materialen mit erhöhten Dampfdruck jeden einzelnen der Vielzahl von Tiegel 14 mit einem druck- und gasdichten Behälter 9 (sogenannte Ampullen) zu umgeben und das Temperaturfeld T von außen aufzuprägen. Beide Methoden sind eher sogenannten "gradient freeze" Verfahren zuzuordnen.

Die Erfindung wird bevorzugt mit dem VGF-Verfahren eingesetzt. Tiegel und Heizer werden relativ zueinander nicht verfahren. Durch gezielte Steuerung der Leistungsversorgung der Heizer wird das Temperaturfeld entsprechend dem Vorstoß der Kristallisationsfront angepasst.

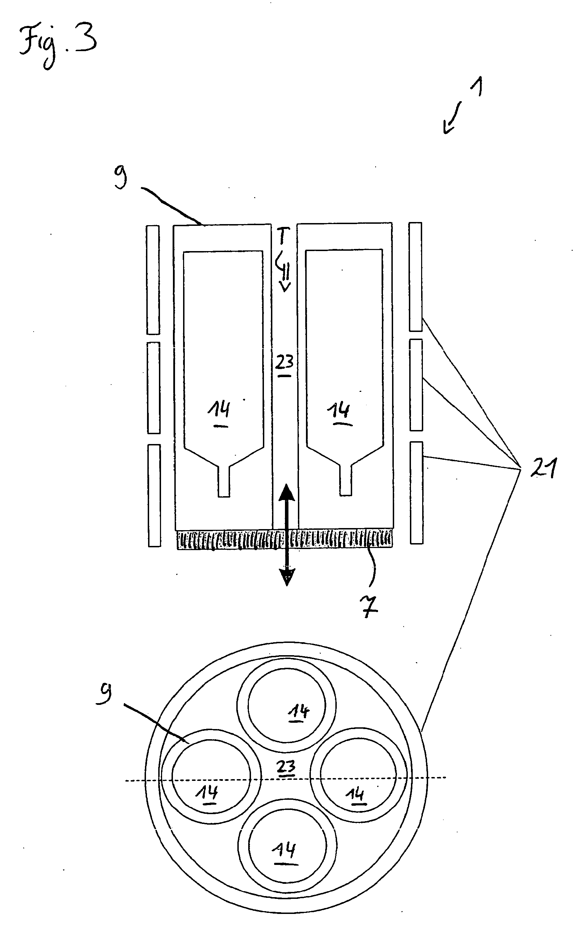

Im Unterschied dazu werden bei Bridgman-artigen Verfahren (z.B. Vertical Bridgman, VB) die Tiegel - unter Umständen auch in einem gasdichten Behälter verschlossen - in einem ortsfesten Temperaturfeld T axial, d.h. in Feldrichtung, verschoben (vgl. Fig. 3). In der in Figur 3 gezeigten Anordnung 1, die auch mit der Erfindung realisiert werden kann, wird dies anhand einer schematisch dargestellten, verfahrbaren Halterung 7 und eines Motors (nicht dargestellt) bewerkstelligt.

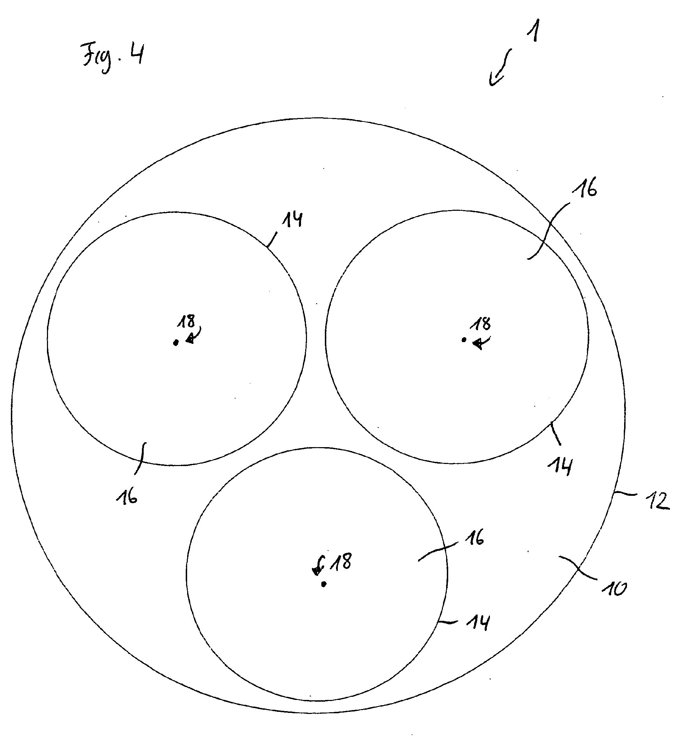

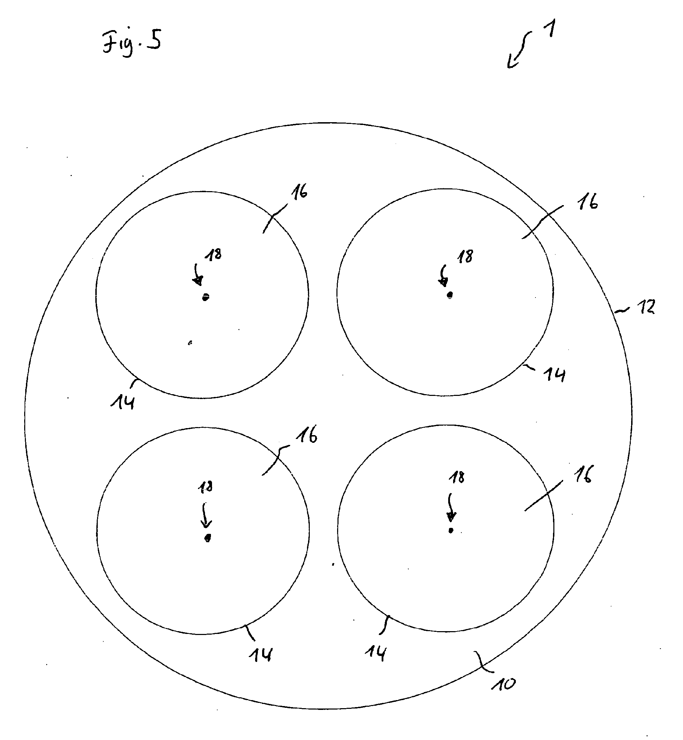

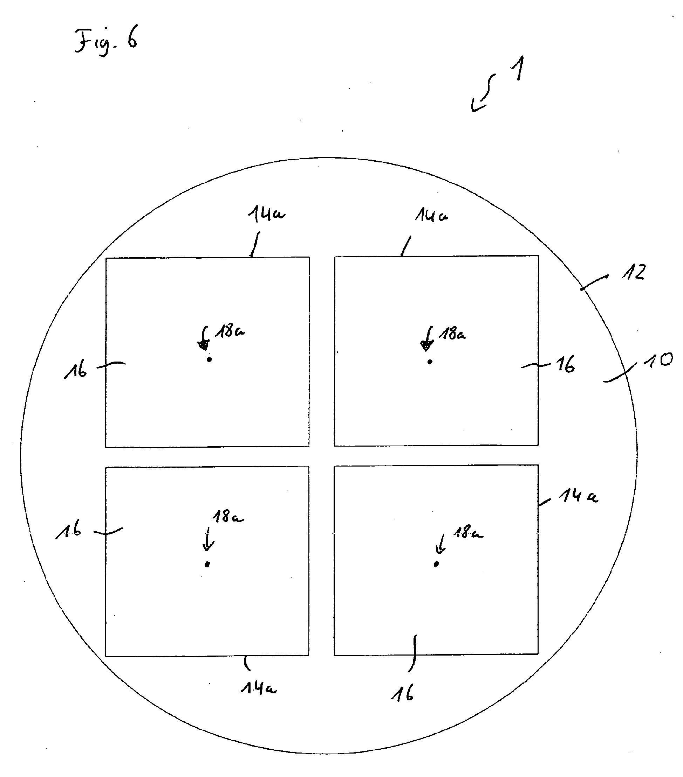

Die Figuren 4 bis 9 zeigen weitere beispielhafte Querschnitte von Tiegelanordnungen (schematische Draufsicht), die ebenfalls im Zusammenhang mit den Ausführungsbeispielen der Erfindung eingesetzt werden können: Form, Anzahl und geometrische Anordnung der Tiegel 14 können bei nach Bedarf variiert werden. Figur 4 zeigt eine Anordnung 1 mit drei Tiegeln, Fig. 5 die oben beschrieben Form mit vier Tiegeln. Für photovoltaisches Material ist die Anordnung von Tiegeln mit quadratischen Querschnitten denkbar (Fig. 6). In diesem Fall kommen matrixartige Anordnungen mit nem (n = 1, 2, 3,..; m = 2, 3, 4,...) Tiegeln 14a in Betracht. Die Längsachse wird in Figur 6 mit dem Bezugszeichen 18a angedeutet.

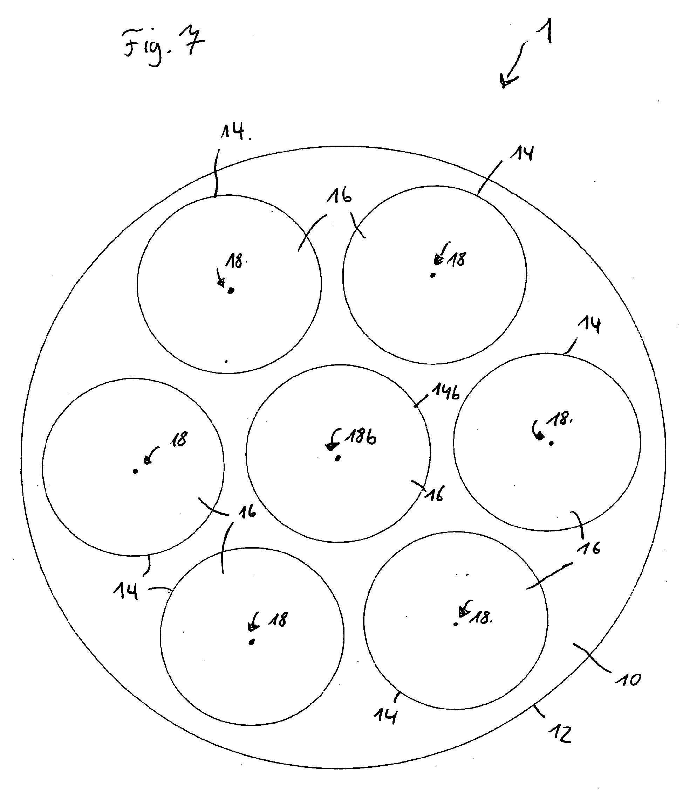

Figur 7 zeigt sechs konzentrisch um einen mittleren Tiegel 14b gruppierte Tiegel 14. Die Anordnung ist rotationssymmetrisch um eine Achse 18b, die in Fig. 7 senkrecht zur Zeichenebene steht. Die Rotationssymmetrie ermöglicht eine leichtere Handhabung von Inhomogenitätseffekten, weil die äußeren Bedingungen, die auf die Tiegel 14 auf ein und demselben Kreis einwirken, nahezu die gleichen sind.

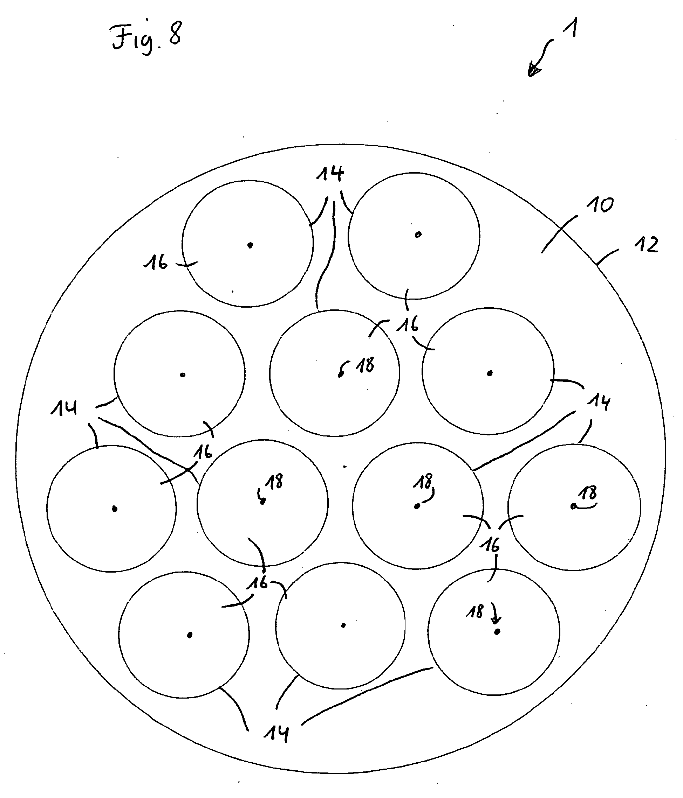

Figur 8 zeigt demgegenüber eine matrixartige, hexagonale Anordnung 1 on Tiegeln 14. Hier wird eine sehr hohe Packungsdichte der Tiegel 14 erreicht.

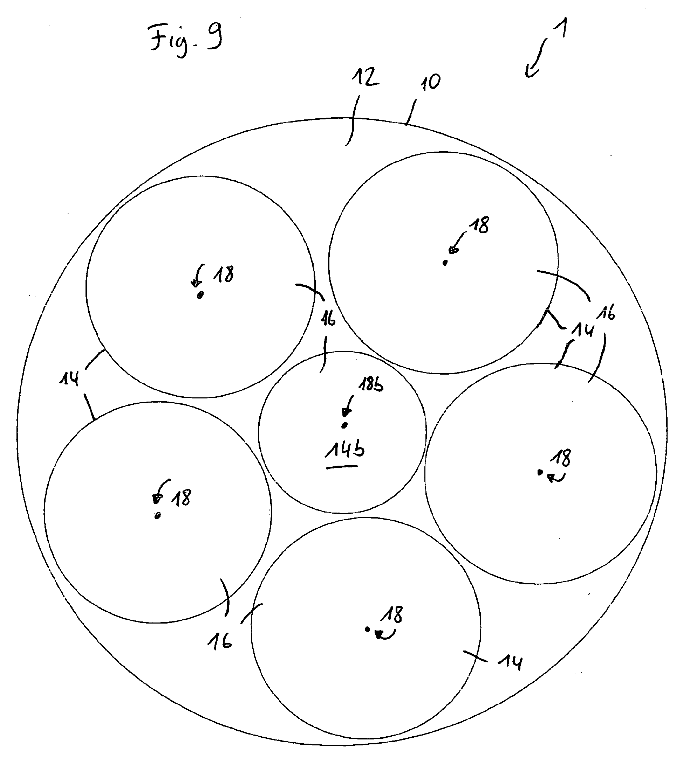

Das Verhältnis der Länge zum Durchmesser einzelner Tiegel ist jeweils größer als 1:1. Die jeweiligen Längen und Durchmesser der Tiegel 14 im Vergleich zueinander sind bevorzugt identisch, jedoch kann der Durchmesser der Tiegel auch unterschiedlich sein, wie es in Fig. 9 mit Bezug auf den mittleren Tiegel 14b gezeigt ist. Die Durchmesser der Tiegel gemäß den Ausführungsbeispielen können 3", 4", 6", 8" oder größere Werte betragen. Natürlich sind auch Zwischenwerte des Durchmessers möglich.

Die Gesamtanordnung besitzt einen Durchmesser, der viel größer ist als deren Höhe, die wiederum im Wesentlichen mit der Länge der Tiegel skaliert.

Die Tiegelwände können in allen hier beschriebenen Ausführungsbeispielen aus pBN gefertigt sein (A.G. Fischer, J. of Electr. Chem. Society, 20(4), 1970; S.E. Blum et al., Brief Communications of the Electr. Chem. Society, 20(4), 1972). Die Erfindung ist jedoch nicht darauf beschränkt.

Ein Ziel ist es nun, das Temperaturfeld derart auszubilden, dass die gewünschten Materialeigenschaften auch dann erhalten werden, wenn viele große Kristalle simultan gezüchtet werden sollen. Konkret werden hier dazu folgende Bedingungen erfüllt:

1. die Ankeimposition liegt für alle Tiegel in der gleichen Höhe in Bezug auf die Richtung des Temperaturfelds liegt, damit ein stabiles und reproduzierbares Ankeimen möglich ist.

2. ein axialer Wärmefluss (axial: in Richtung des Temperaturgradienten) wird derart ausgebildet, dass die Erstarrungsfront im wesentlichen flach und zudem möglichst symmetrisch zur Achse des jeweiligen Kristallisationstiegels verläuft, um einerseits die auftretenden thermoelastischen Spannungen gering und um andererseits die Variation der wesentlichen Eigenschaften eines nachfolgend aus dem Kristall zu fertigenden Wafers (nämlich der elektrische Widerstand, die Dotierstoffkonzentration, der Restspannungsgehalt, die Versetzungsdichte etc.) in akzeptablen Grenzen zu halten.

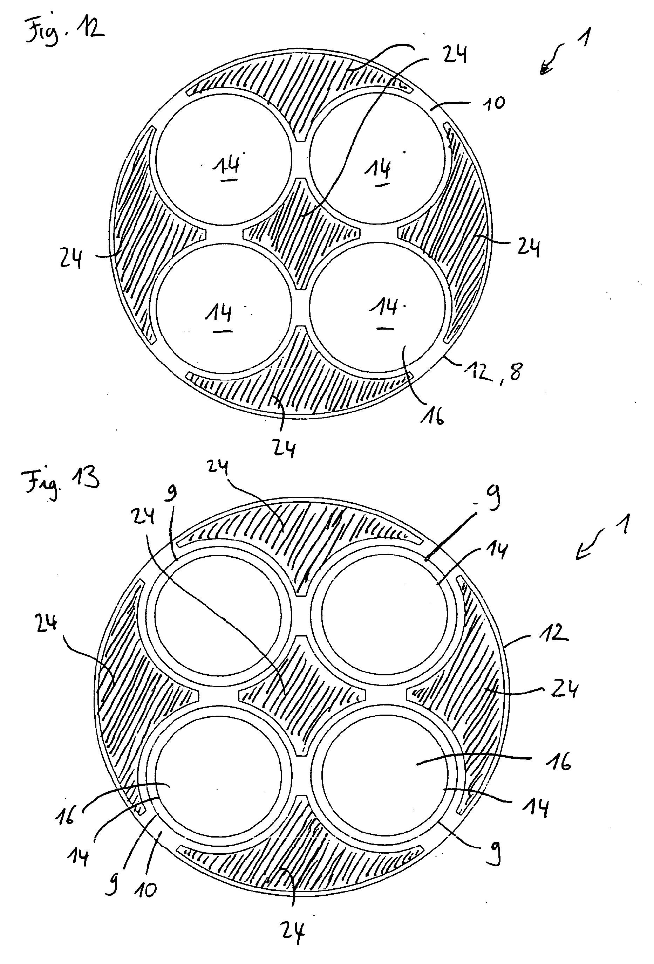

Ein erstes, mit jeder der in den Fig. 1-9 gezeigten Anordnungen kompatibles Ausführungsbeispiel weist eine Einrichtung zur Homogenisierung des Temperaturfelds in einer Ebene senkrecht zur Erstarrungsrichtung auf, die wärmetechnisch optimierte Bauteile umfasst. Eine Ausführungsform ist in Fig. 12 gezeigt. Diese Bauteile können als Füllkörper 24 ausgebildet sein.

Die Räume zwischen den Tiegeln werden mit diesen speziellen Füllkörpern 24 ausgefüllt. Insbesondere sind die Füllköper 24 in diesem Ausführungsbeispiel in ihrer Form an die Zwischenräume 23 (vgl. z.B. Fig. 1-3) zwischen den Tiegeln angepasst. Es handelt sich hier bevorzugt um eine Vielzahl physisch getrennt voneinander vorliegender Füllkörper 24. Jeder ist einzeln einsetzbar bzw. entnehmbar. Durch Auswahl von Füllkörpern unterschiedlicher Materialeigenschaften hinsichtlich Wärmeleitfähigkeit kann gezielt auf den Wärmefluss in der Gesamtanordnung Einfluss genommen werden.

Durch die Füllkörper 24 wird zum einen die unerwünschte Wärmeübertragung durch turbulente Gaskonvektion, die bei Züchtungstechnologien unter Verwendung von erhöhten Inertgasdrücken auftritt, und eine gegebenenfalls unkontrollierbare Wärmestrahlung unterdrückt. Das Temperaturfeld wird so einzig durch den Mechanismus der Wärmeleitung zwischen Wärmequellen, nämlich den Heizern, und die latente Wärme des Phasenübergangs sowie den Wärmesenken, nämlich den gekühlten Anlagenwänden 12 bestimmt.

Durch die Füllköper 24 kann die Brechung der in Einzel-Tiegelanlagen üblichen Rotationssymmetrie bezüglich der Tiegellängs- oder Rotationsachse 18 ausgeglichen werden. Als Materialien für Füllkörper 24 eignen sich insbesondere solche, deren Wärmeleitfähigkeit an die der zu erstarrenden Substanz angepasst ist. Dazu können beispielsweise Graphite, Keramiken oder Faserwerkstoffe mit angepasster Dichte verwendet werden.

Eine besondere Ausgestaltung sieht vor, Füllkörper 24 mit anisotropen Wärmeleitfähigkeiten einzusetzen. In (axialer) Richtung des Erstarrungsfortschritts entspricht hier die Wärmeleitfähigkeit derjenigen des zu erstarrenden Materials. Senkrecht dazu (also in der in Fig. 4-9 gezeigten Ebene bzw. in radialer Richtung) ist die Wärmeleitfähigkeit in den Füllkörpern 24 vergleichsweise hoch. Dadurch werden Temperaturgradienten in radialer Richtung von der Rotationsachse 18 aus gesehen unterdrückt.

Faserwerkstoffe oder Verbundwerkstoffe mit speziell ausgerichteten Fasern (Keramikfaserwerkstoffe oder Kohlenfaser verstärkte Werkstoffe) oder lameliierte Verbundwerkstoffe erfüllen diese Forderungen. Die grundsätzlichen Eigenschaften solcher Stoffe sind dem die Erfindung nacharbeitenden Fachmann bekannt.

Insbesondere kann auch Graphit mit solchen Eigenschaften hergestellt werden. Dazu gehören beispielsweise hochtemperaturresistente Graphitfilze oder -folien mit Wärmeleitfähigkeiten von 20-40 W/mK in der Folienebene und 2-10 W/mK in der Richtung senkrecht dazu. Solche Filze lassen sich zu Stapeln schichten. Die Materialien können auch u.a. durch CVD-Prozesse zu unterschiedlicher Dichte verdichtet werden, welches dann auch wieder zu unterschiedlichen Wärmeleiteigenschaften führt. In Kombination - oder auch als spezieller "Gradientenwerkstoff" gefertigt - gibt die Schichtausrichtung der Folien höherer Dichte auch die Richtung des stärksten Wärmeflusses an. Anders ausgedrückt: stärker isolierende Zwischenschichten mindern den Wärmefluss senkrecht zu der betreffenden Schicht.

Graphitmaterialien mit anisotropen Wärmeleiteigenschaften sind z.B. erhältlich von den Firmen Calcarb Ltd, Bellshill, North Lanarkshire, Scotland, UK, oder Schunk Graphite Technology, LLC, Menomonee Falls, Wisconsin, US, oder SGL Carbon AG, Wiesbaden, Hessen, DE.

Die Anordnung gemäß dem ersten (und dem folgenden zweiten) Ausführungsbeispiel kann zum Beispiel wie bei einem Tamann-Stöber-Aufbau für die Durchführung des VGF-Verfahrens konfiguriert sein, so wie es weiter unten im Zusammenhang mit dem dritten Ausführungsbeispiel noch beschrieben wird.

Figur 13 zeigt eine Modifikation des Beispiels aus Figur 12, wobei die Tiegel 14 jeweils einzeln in gas- und druckdichten bzw. vakuumdichten Behältern 9 (Ampullen) angeordnet sind. Die Füllkörper 24 füllen dabei die Zwischenräume zwischen den Ampullen aus.

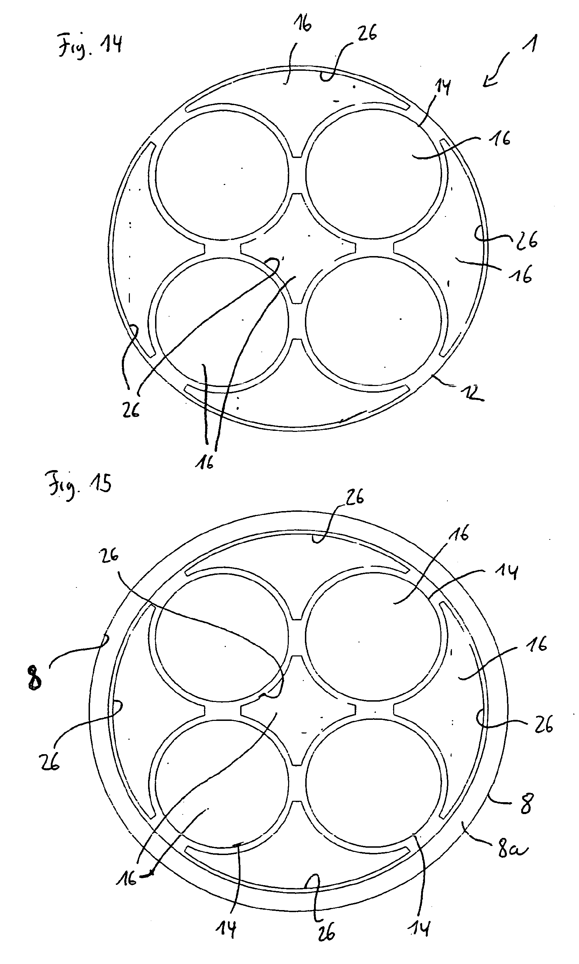

Ein zweites, zum vorhergehenden Ausführungsbeispiel ähnliches Ausführungsbeispiel ist in Fig. 14 gezeigt und bezieht sich auf das Einbringen von Zwischentiegeln 26 in die Zwischenräume 23 zwischen den Tiegeln 14.

Die Räume zwischen den Kristallisationstiegeln werden mit speziell geformten Tiegeln 26, die das gleiche oder ähnliches Material wie dasjenige enthalten, das auch im (Haupt-)Tiegel 14 kristallisieren soll, hier als Fülltiegel bezeichnet, ausgefüllt. Hier ergibt sich der besondere Vorteil nahezu gleicher wärmephysikalischer Parameter. Das Material in den Fülltiegeln kann wieder benutzt werden (als Schmelze) und altert kaum.

Beispielsweise kann die Schmelze 16 in den Haupttiegeln 14 im Wesentlichen aus GaAs enthalten und in den Zwischentiegeln 16 ebenfalls GaAs umfassen.

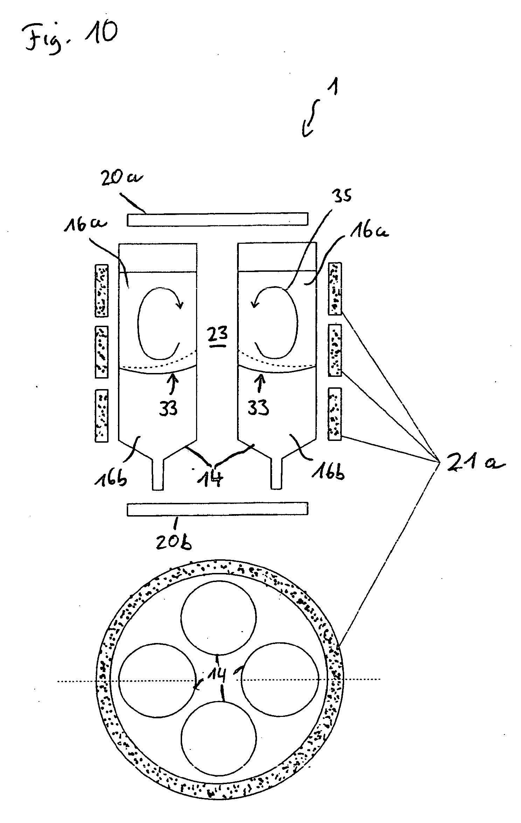

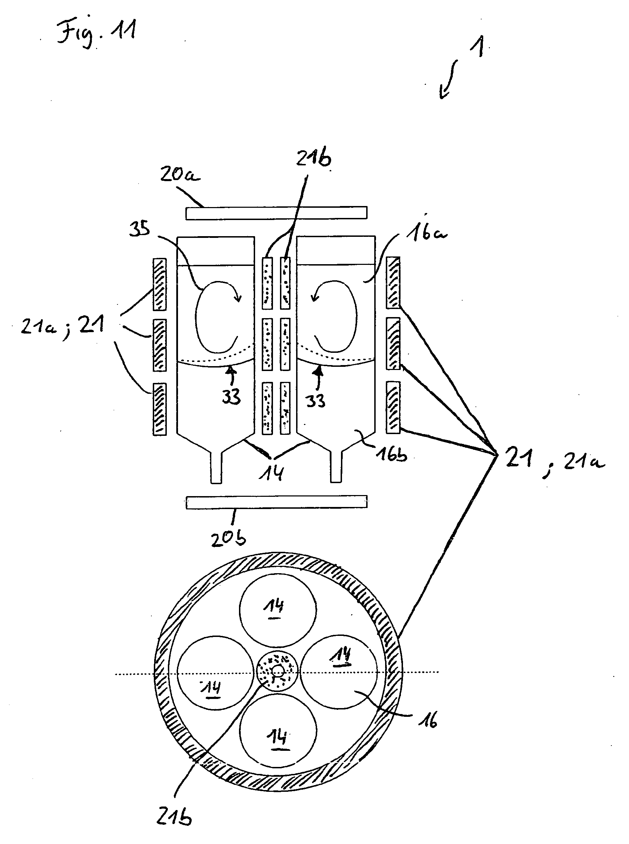

Ein weiterer Vorteil besteht darin, dass das Material in den Fülltiegeln ebenfalls erstarrt und so in direkter Nachbarschaft zu den wachsenden Kristallen latente Wärme frei wird. Ein derartiges vertikales Temperaturprofil unter Berücksichtigung der latenten Wärme der eigentlichen Schmelze kann von anderweitigen Füllstoffen kann durch andere Füllstoffe als das Schmelzmaterial selbst nur schwer widergespiegelt werden. Unerwünschte radiale Wärmeflüsse können so kompensiert werden. Im Ergebnis kann die Phasengrenzdurchbiegung 33 (siehe Figur 10 oder 11) mit Vorteil verringert werden.

Das erste und zweite Ausführungsbeispiel ist mit den in den Fig. 1-9 gezeigten Anordnungen von Tiegeln 14 im Ofen 10 kompatibel und kann erfindungsgemäß entsprechend abgewandelt werden.

Ein drittes Ausführungsbeispiel ist in Fig. 10 gezeigt. Das dritte Ausführungsbeispiel sieht als besonderes Merkmal eine Vorrichtung 21a zur Erzeugung magnetischer Wanderfelder vor. Aufgrund der Eigenschaften des Schmelzmaterials spricht dasselbe auf solche Felder an, so dass eine Konvektion in den Schmelzen der einzelnen Züchtungstiegeln 14 hervorgerufen werden kann. Die Konvektionen können dem durch die Parallelanordnung der Tiegel verursachten Symmetriebruch entgegenwirken.

In dem Ausführungsbeispiel der Fig. 10 ist eine Anordnung zur VGF-Züchtung von GaAs in einem Tammann-Stöber-Aufbau gezeigt (zum Tamann-Stöber-Aufbau: siehe Wilke, K.-Th. and J. Bohm in "Kristallzüchtung", Ed. K.-Th. Wilke, 1. Auflage ed. VEB Deutscher Verlag der Wissenschaften, 1973, 1-922). Es sind 3 aktive Widerstandsheizer Deckelheizer 20a, als Mantelheizer eingerichtete Vorrichtungen 21a zur Erzeugung magnetischer Wanderfelder und Bodenheizer 20b vorgesehen.

Zwischen dem Deckel- und dem Bodenheizer wird der Temperaturgradient eingestellt, die Vorrichtung 21a wirkt wie beim konventionellen Mantelheizer 21 wie oben beschrieben radialen Wärmeflüssen entgegen. Innerhalb dieser Heizeranordnung sind mehrere Tiegel mit Durchmessern von z.B. 3x200 mm, 4x150 mm, 6x125 mm, 12x100 mm oder 12x75 mm vorgesehen (vgl. Fig. 4-9). Die Tiegel 14 sind - wie in den anderen Ausführungsbeispielen auch - in symmetrischer Konfiguration positioniert.

In dieser Anordnung 1 wird nun der Magnetfeldheizer 21a derart eingerichtet, dass die Form der Phasenfront bezüglich der Achse 18 jedes Einzeltiegels symmetrisiert wird (siehe Fig. 6). Magnetfeldheizer 21a sind beispielsweise in der Druckschrift WO 2005/041278 A2 beschrieben. Innerhalb eines Hochdruckkessels 8 sind demnach Graphitstäbe spiralförmig um einen Tiegel gewunden, so dass sie drei Abschnitte ausbilden, die je eine Spule repräsentieren. Mit phasenverschobener Spannung beaufschlagt (Drehstrom) sorgen diese Spulen für geeignete magnetische Wanderfelder. Eine zusätzliche Versorgung mit Gleichstrom stellt in den Spulen eine Widerstandsheizung sicher.

Für die erfindungsgemäße Ausführungsform wird ein Magnetfeldheizer des beschriebenen Typs so realisiert, dass er die symmetrische Anordnung von Tiegeln in ihrer Gesamtheit innerhalb des Hochdruckkessels umgibt, also gerade nicht einzelne Tiegel. Diese Anordnung ist allerdings auf Fälle begrenzt, bei denen die Tiegel auf höchstens einem Kreis um die Symmetrieachse der Tiegelanordnung konfiguriert sind. Ein weiterer Tiegel kann sich mit Vorteil zusätzlich im Symmetriezentrum (in der Mitte) der Anlage befinden.

Zusätzlich kann statt des zentralen Tiegels eine weitere Magnetfeldanordnung (Magnetfeldheizer 21b) zur Unterstützung bzw. Dämpfung des äußeren Magnetfeldes eingebracht werden, um die Phasengrenzen zusätzlich zu beeinflussen. Eine ähnliche Anordnung 1 ist in Fig. 11 gezeigt (dort außen mit konventionellem Mantelheizer 21 oder alternativ mit Magnetfeldheizer 21a). Dabei kann also die Erzeugung des Magnetfeldes ganz oder auch nur teilweise von der inneren bzw. äußeren Magnetfeldanordnung übernommen werden.

In den äußeren Tiegeln (vgl. Fig. 5) treibt das rotierende (wandernde) magnetische Feld (RMF)in der Größenordnung von einigen mT eine Konvektionsrolle 35 (vgl. Fig. 10, 11), die einen zusätzlichen Wärmetransport in der Schmelze 16a oberhalb des erstarrten Materials 16b verursacht. Dieser Wärmestrom kann so dimensioniert werden, dass er einer asymmetrischen Ausbildung der Phasengrenze 33 entgegenwirkt. Die asymmetrische Ausbildung käme ansonsten durch eine stärkere Gaskonvention im mittleren Zwischenraum 23 der Anordnung 1 als im Vergleich zu einem schmalen Raum etwa zwischen Tiegel und äußerem Mantelheizer zustande.

In vielen Materialien sind strukturelle Perfektion und elektrische Homogenität sich widersprechende Eigenschaften. Dies ist im wesentlichen der allgemein bekannten Wechselwirkung zwischen extrinsischen und intrinsischen Punktdefekten, die für elektrische und optische Materialeigenschaften verantwortlich sind, und Strukturdefekten wie z.B, Versetzungen bzw. Korngrenzen zuzuschreiben. Hier wird eine Mikrosegregation beobachtet. Sind nun die Strukturdefekte sehr dicht, dann sind die Konzentrationsinhomogenitäten klein und die Homogenität der elektrischen bzw. optischen Eigenschaften groß. Im umgekehrten Falle sind die mittleren Abstände zwischen Strukturdefekten so groß, dass in Folge der Mikrosegregation relativ große Konzentrationsunterschiede für Punktdefekte auftreten. Im Folgenden werden einige bekannte Messmethoden für wesentliche Eigenschaften der durch die Anordnung gewonnenen Einkristalle und deren Homogenität beschrieben:

Zu den die elektrischen Eigenschaften beschreibenden Parametern zählen der spezifische elektrische Widerstand p und die Störstellendichte des EL2-Niveaus.

Die ortsaufgelöste Messung des spezifischen elektrischen Widerstandes p ist mit der sogenannten COREMA (COntactless REsistivity MApping) möglich (Jantz, W. and Stibal, R. in: "Contactless resistivity mapping of semi-insulating substrates. III-Vs Review 6[4], 38-39. 1993; und Stibal, R., Wickert, M., Hiesinger, P., and Jantz, W. in "Contactless mapping of mesoscopic resistivity variations in semi-insulating substrates", Materials Science and Engineering B 66 [1-3], 21-25, 1999). Die typische Ortsauflösung des Verfahrens liegt im Bereich von 1 mm², das Mapping ist vollflächig.

Die laterale Verteilung der beim GaAs besonders wichtigen Störstellen EL2 kann mit einer ortsaufgelösten Transmissionsmessung bei 1000 nm Wellenlänge gemessen werden (Wickert, M., et al. in "High Resolution EL2 and Resistivity Topography of SI GaAs Wafers", IEEE Inc., 1998, V 21-24; Wickert, M., et al. in "Comparative High Resolution EL2 and Resistivity Topography of Semi-Insulating GaAs Wafers", June 1, 1998 Piscataway, NJ: IEEE Inc., 1999).

Auch die mechanischen Restspannungen von Wafern spielen bei der Weiterverarbeitung eine große Rolle. Sie entstehen, wenn die thermoelastischen Spannungen beim Abkühlen der Kristalle bei erhöhten Temperaturen durch die Bildung von Versetzungen relaxieren. Es ist klar, dass die bei Raumtemperatur gemessene Restspannung wesentlich von der Beschaffenheit des Temperaturfeldes während der Züchtung und des Abkühlens des Kristalls abhängt. Die Restspannungen eines Wafers können mittels Depolarisation von polarisiertem Licht in einem verspannten Medium gemessen werden. In "Photoelastic characterization of residual stress in GaAs-Wafers", H.D. Geiler et al., Materials and Science in Semiconductor Processing 9, (2006) p.345-350 wird eine Methode zur ortsaufgelösten Messung dieser Depolarisation beschrieben, die es erlaubt Restspannungskomponenten zu messen. Alle hier angegebenen Werte sind nach dieser Methode ermittelt worden.

Ein mit der Restspannung zusammenhängender Parameter ist die Versetzungsdichte bzw. die Dichte von Korngrenzen. Sie kann beispielsweise durch die Ätzgrubendichte (epd, etch pit density) repräsentiert sein. Dabei wird die glatte Waferoberfläche einem Ätzmaterial aus KOH ausgesetzt, wobei an den Durchstoßpunkten der Versetzungen Gruben (pits) in die Oberfläche geätzt werden, die zur Bestimmung der Flächendichte gezählt werden können.

Die Bestimmung der Standardabweichungen erfolgte nach folgendem mathematischem Schema (am Beispiel des spezifischen elektrischen Widerstands $\rho$):

Die Messdaten der Punkte wurden aufgeteilt: für jeden Punkt (x,y) in der Waferebene (der gezüchtete Kristall musste dazu zersägt werden) wurde eine Regressionsebene errechnet aus den Messdaten solcher benachbarter Punkte, die im Inneren eines Umkreises mit dem Radius $\zeta$ von ihm liegen:

$$\rho_{measured} = \rho_{regression\ plane} + \rho_{variation}$$

Der gemessene Widerstand wird dann als Summe zweier Summanden ausgedrückt. Dabei ist Progression plane der Wert der Regressionsebene im Punkt (x,y) und $\rho_{variation}$ bezeichnet den Abstand zwischen dem Funktionswert der Regressionsebene und dem gemessenen Wert.

Ein least-squares-fit einer Ebene p(x,y) =a+bx+cy für N Datenpunkte kann eineindeutig durch die Lösung des linearen Gleichungssystems

$$\begin{pmatrix} N & \sum x_i & \sum y_i \\ \sum x_i & \sum x_i^2 & \sum x_i y_i \\ \sum y_i & \sum x_i y_i & \sum y_i^2 \end{pmatrix} \begin{pmatrix} a \\ b \\ c \end{pmatrix} = \begin{pmatrix} \sum \rho_i \\ \sum x_i \rho_i \\ \sum y_i \rho_i \end{pmatrix}$$

erhalten werden. Für die Homogenitäten auf verschiedenen Längenskalen können nun dienen:

die totale Standardabweichung:

$$\sigma_{total} = \sqrt[2]{\frac{\sum_{i=1}^{N} (\rho_i - \bar{\rho})^2}{N-1}} \ \text{ mit } \ \bar{\rho} = \frac{1}{N}\sum_{i=1}^{N}\rho_i \ ;$$

die lokale Standardabweichung: 
$$\sigma_{lokal} = \sqrt[2]{\frac{\sum_{i=1}^{N} (\rho_i - \rho_{p_i})^2}{N-1}} \ , \quad \text{mit } \rho_{p_i} \text{ als Funktionswert der Regressionsebene}$$

im Punkt $(x_i, y_i)$; und

die globale Standardabweichung:

$$\sigma_{global} = \sqrt[2]{\frac{\sum_{i=1}^{N} (\rho_{p_i} - \bar{\rho}_p)^2}{N-1}} \ , \ \text{mit } \ \bar{\rho}_p = \frac{1}{N}\sum_{i=1}^{N}\rho_{p_i} \ .$$

Zu einer genaueren Betrachtung wird die Meßgröße (der Parameter) auf verschiedenen Längenskalen untersucht. Als lokal wird vorliegend etwa ein Bereich in der Größenordnung weniger Versetzungszellen bzw. Körner(der Radius $\zeta$ beträgt 5 - 10 mm) bezeichnet. Als global werden Schwankungen über den gesamten Wafer mit einer minimalen Auflösung des Radius $\zeta$ bezeichnet. Die Schwankungen auf unterschiedlichen Längenskalen können auf physikalisch unterschiedlichen Ursachen beruhen.

Für die getrennte Betrachtung lokaler und globaler Schwankungen einer Messgröße (des gemessenen Parameters) ist die Messung von Mappings mit hoher lateraler Auflösung erforderlich. Meßfelder, die einen geringeren Abstand zum Waferrand als der Randausschluss besitzen, werden in der Auswertung nicht berücksichtigt.

Es können gemäß der hier vorgeschlagenen Betrachtungsweise zwei Größen festgelegt werden: ein Randausschluss und eine charakteristische Länge $\zeta$, danach ist die numerische Berechnung der Größen eindeutig festgelegt und durch jedermann zu reproduzieren.

Alternativ zur vorgeschlagenen Betrachtung ist aber auch eine Fourierfilterung möglich.

Es wurde nun herausgefunden, dass durch die Erfindung besonders hervorragende Eigenschaften der erhaltenen Kristalle hinsichtlich der Homogenität sowohl der elektrischen wie auch der mechanisch-strukturellen Parameter erreicht werden. Und zwar gilt dies insbesondere für globalen (nichtlokale) Schwankungen über den Wafer hinweg.

Beim COREMA-Mapping des spezifischen elektrischen Widerstands p wird nun die globale Schwankung durch eine langsame Variation des Defekthaushaltes bestimmt, während lokale Schwankungen durch eine Variation der E12 Störstellenkonzentration mit der Versetzungsstruktur bestimmt sind. Da die globalen Schwankungen größer sind als die lokalen, ist die Standardabweichung über alle Messwerte des spezifischen elektrischen Widerstands eher ein Maß für die globale Variation. Lokale Schwankungen wurden daher bisher kaum betrachtet.

Bei der Bestimmung der Ätzgrubendichte epd hängt die Standardabweichung über alle Messwerte sehr empfindlich von der Messfeldgröße ab. Die Variation von Messfeld zu Messfeld ist sehr groß, so dass im Gegensatz zum COREMA-Mapping die Standardabweichung über alle Werte die lokale Fluktuation angibt. Hier wurde daher bisher die globale Variation kaum betrachtet.

Die Verteilungen von Scherspannungen eines Wafers (senkrecht zur Kristallachse geschnitten) mit SIRD gemessen kann statistisch ausgewertet werden. Dabei ergibt sich eine Lorentzverteilung, die symmetrisch um Null liegt. Die Halbwertsbreite der Verteilung kann als Maß der lokalen Verspannung des Materials interpretiert werden.

Als Messresultate für die Widerstandshomogenität wurden folgende Werte der Standardabweichung - bezogen auf einen Mittelwert für den Widerstand - für einen 6"-VGF-Wafer erhalten:

$\sigma_\rho$ total = 6,5%
$\sigma_\rho$ global = 5,3%
$\sigma_\rho$ lokal = 2,5%

Für spezielle erfindungsgemäße Anordnungen erhielt man sogar folgende Werte:

$\sigma_\rho$ total = 4,5%
$\sigma_\rho$ global = 2,8%
$\sigma_\rho$ lokal = 1,25%

Alle Messungen wurden mit 200x200 Punkten Auflösung, einer Mittelung über $\zeta$ = 10 mm und einem Randausschluss von 3 mm durchgeführt.

Bezüglich der Homogenität der epd-Auszählung (Ätzgrubendichte) wurden nun folgende Standardabweichungen (wie oben relativ zu einem Mittelwert) bestimmt:

$\sigma_{epd}$ total = 90%
$\sigma_{epd}$ global = 23%
$\sigma_{epd}$ lokal = 86%

Für spezielle erfindungsgemäße Anordnungen erhielt man sogar folgende Werte:

$\sigma_{epd}$ total = 76,0%
$\sigma_{epd}$ global = 17,6%
$\sigma_{epd}$ lokal = 67,0%

Eine Mittelung wurde hier über $\zeta$ = 5 mm mit einem Randausschlussbereich auf dem Wafer von 3 mm durchgeführt. Das Mapping erfolgte (vollflächig) auf Flächen der Größe 500x500 $\mu$m.

Es wurde auch die Homogenität der EL2-Störstellendichte für 6" VGF-Wafer bestimmt. Dazu wurden 256 Detektoren linear auf 7,5 mm breiten Streifen angeordnet. Das Mapping wurde vollflächig ausgeführt. Als Randausschluss wurde ein Streifen von 3 mm festgelegt. Die Schrittweite in x-Richtung betrug 570 $\mu$m. In y-Richtung wurde die Auflösung durch bilden des arithmetischen Mittels angepasst. Dabei wurden 21 Streifen ä 256 Messpunkte, also N = 5376 Datenpunkte in y-Richtung erhalten. Jeweils k(i) aufeinander folgende Werte werden durch Mittelwertbildung zusammengefasst:

```
k(i) = floor(i*256/N) - floor((i-1)*256/N), i=1…N
```

Die Funktion floor(x) entspricht der Gaußklammer.

Folgende Werte wurden für die Standardabweichung (in Prozent bezogen auf den Mittelwert) erhalten:

$$\sigma_{El2} \text{ total} = 10,7\ \%.$$

Für die lokalen und globalen Werte ergab sich relativ dazu:

$$\sigma_{El2} \text{ global} < 0.8* \sigma_{El2} \text{ total}$$

$$\sigma_{El2} \text{ lokal} < 0.7* \sigma_{El2} \text{ total}$$

Eine Mittelung wurde hier über $\zeta$ = 10 mm mit einem Randausschlussbereich auf dem Wafer von 3 mm durchgeführt.

Ferner wurde auch die durch eine erfindungsgemäße Anordnung erhaltene Homogenität bezüglich des Rokking-Kurven-Mappings bestimmt. Die Rockingkurvenmappings werden mit einem kommerziell erhältlichen, hochauflösenden Röntgendiffraktometer aufgenommen, welches mit Cu-K$\alpha_1$ Strahlung sowie eingangsseitig mit einer kollimierenden Optik arbeitet. Die Schrittweite in $\omega$ ist so gewählt, dass in der Halbwertsbreite mindestens 6 Messpunkte liegen, d.h. sie beträgt maximal 1,5 arcsec. Bei der Messung auf der Probenoberfläche wird der {004} Reflex (Rockingrichtung <110>) verwendet und die Schrittweite in x- und y-Richtung beträgt höchstens 2x2 mm. Mindestens 2000 Counts sind im Maximum zugrunde gelegt. Die lateralen Abmessungen des Röntgenfokus liegen bei $\leq$ 1 mm (Streuebene) bzw. 2 mm (senkrecht zur Streuebene) auf der Oberfläche. Der Randausschlussbereich betrug 2 mm vom Waferrand. Die Bestimmung der Halbwertsbreite (FWHM) fand ohne Korrektur der Auflösungsfunktion statt.

Die Verteilung der Rockingkurven-Linienbreiten fand den Messergebnissen zufolge ihr Maximum bei etwa 10 arcsec. Die Halbwertsbreite der Verteilung von gemessenen Halbwertsbreiten betrug etwa 1 arcsec (etwa 10 Prozent). Weniger als 1 Promille der Halbwertsbreiten überschritt 15 arcsec. Die maximal gemessene Halbwertsbreite lag bei unter 18 arcsec (Bogensekunden).

Folgende Werte wurden für die Standardabweichung (in Prozent bezogen auf den Mittelwert) erhalten:

$$\sigma_{FWHM} \text{ total} = 7{,}0 \text{ \%}.$$

Für die lokalen und globalen Werte ergab sich relativ dazu:

$$\sigma_{FWHM} \text{ global} < 0.8* \sigma_{FWHM} \text{ total}$$

$$\sigma_{FWHM} \text{ lokal} < 0.6* \sigma_{FWHM} \text{ total}$$

Eine Mittelung wurde hier über $\zeta$ = 10 mm mit einem Randausschlussbereich auf dem Wafer von 2 mm durchgeführt.

Ferner wurden die Scherspannungen von erfindungsgemäß hergestellten Kristallen bestimmt. Mit einem Randausschluss von 2 mm und einer Messauflösung von 200 $\mu$m x 200 $\mu$m ergaben sich für eine Anpassung einer Lorentzverteilung Halbwertsbreiten von kleiner als 100 kPa und für spezielle Anordnungen von kleiner als 65 kPa.

**Patentansprüche**

**1.** Anordnung (1) zur Herstellung eines Kristalls aus der Schmelze (16) eines Rohmaterials, umfassend:

einen Ofen (10) mit einer ein oder mehrere Heizelemente (20, 21) aufweisenden Heizvorrichtung, die zur Erzeugung eines in einer ersten Richtung (18) gerichteten Temperaturfeldes (T) in dem Ofen (10) eingerichtet ist, eine Vielzahl von wenigstens zwei Tiegeln (14) zur Aufnahme der Schmelze (16), die nebeneinander in dem gerichteten Temperaturfeld (T) angeordnet sind, und
eine Einrichtung (21a, 21b, 46, 26) zur Homogenisierung des Temperaturfelds (T) in einer Ebene senkrecht zu der ersten Richtung (18) in den wenigstens zwei Tiegeln (14),
wobei die Einrichtung zur Homogenisierung des Temperaturfelds ein Füllmaterial (24) umfasst, das in einem Zwischenraum (23) zwischen den Tiegeln (14) angeordnet ist, wobei das Füllmaterial (24) eine anisotrope Wärmeleitung bewirkt, wobei
eine erste Komponente der Wärmeleitung in der ersten Richtung (18) geringer als eine zweite Komponente der Wärmeleitung entlang der zu der ersten Richtung (18) senkrechten Ebene ist, um in dieser Ebene einen schnellen Temperaturausgleich zwischen den Tiegeln zu ermöglichen.

**2.** Die Anordnung (1) gemäß Anspruch 1, wobei die
Tiegel jeweils in einem gas-, vakuum- und/oder druckdichten Behälter (9) angeordnet sind, und das Füllmaterial (24) zwischen den gas-, vakuum- und/oder druckdichten Behältern (9) und außerhalb dieser Behälter (9) eingebracht ist, oder
die Tiegel (14) gemeinsam innerhalb eines gas-, vakuum- und/oder druckdichten Kessels (8) angeordnet sind, und das Füllmaterial (24) innerhalb des Kessels (8) zwischen den Tiegeln (14) angeordnet ist.

**3.** Die Anordnung (1) gemäß einem der Ansprüche 1 oder 2, bei der
das Füllmaterial (24) einen an das Material der Rohschmelze angepassten Wärmeleitkoeffizienten aufweist.

**4.** Die Anordnung (1) gemäß einem der Ansprüche 1 bis 3, bei der
das Füllmaterial (24) ein Material aus der Gruppe umfassend: Graphit, Keramik oder Faserwerkstoff, ist, oder

das Material der Rohschmelze (16) umfasst, wobei das das Material der Rohschmelze (16) umfassende Füllmaterial in Zwischentiegeln (26) eingefüllt ist, deren äußere Form an diejenige der Vielzahl von Tiegel (14) angepasst ist, um den Zwischenraum (23) zwischen den Tiegeln (14) oder im Fall der gas-, vakuum- und druckdichten Behälter (9) zwischen den die Tiegel (14) enthaltenden Behältern (9) auszufüllen.

5. Die Anordnung (1) gemäß einem der Ansprüche 1 oder 2, bei der
eine erste Komponente der Wärmeleitung in der ersten Richtung (18) geringer als die Wärmeleitung des von den Tiegeln (14) aufzunehmenden Materials der Rohschmelze (16) ist, oder
eine zweite Komponente der Wärmeleistung in der zu der ersten Richtung (18) senkrechten Ebene größer oder gleich der Wärmeleitung des von den Tiegeln (14) aufzunehmenden Materials der Rohschmelze ist, um in dieser Ebene einen schnellen Temperaturausgleich zwischen den Tiegeln zu ermöglichen.

6. Die Anordnung (1) gemäß einem der Ansprüche 1 bis 3, bei der das Füllmaterial (24) ein Faserwerkstoff oder ein lamellierter Verbundwerkstoff ist.

7. Die Anordnung (1) gemäß einem der Ansprüche 1 bis 3, bei der
bei der das Füllmaterial eine Anzahl getrennt voneinander vorliegender Füllkörper mit teilweise unterschiedlicher Materialbeschaffenheit umfasst, die unabhängig voneinander in die Zwischenräume zwischen den Tiegeln der Anordnung einsetzbar sind, und
für mindestens zwei der Füllkörper hinsichtlich der Wärmeleitfähigkeit voneinander unterschiedliche Materialbeschaffenheiten vorgesehen sind, wobei die Eigenschaften des Füllmaterials (24) im Zentrum der Anordnung anders sind als in den Randbereichen.

8. Die Anordnung (1) gemäß einem der Ansprüche 1 bis 3, bei der
die Tiegel (14) um einen gemeinsamen Mittelpunkt herum in azimuthaler Richtung symmetrisch in einem oder mehreren Kreis(en) um den gemeinsamen Mittelpunkt angeordnet sind, oder
die Tiegel (14) in einer hexagonalen Anordnung innerhalb des Ofens (10) plaziert sind, oder
die Tiegel (14a) in der Ebene senkrecht zu der ersten Richtung (18) im Querschnitt jeweils eine Rechteckform besitzen, und matrixförmig in Reihen und Spalten zu jeweils mindestens zwei Tiegeln (14a) angeordnet sind.

9. Die Anordnung (1) gemäß einem der vorhergehenden Ansprüche, bei der die Einrichtung zur Homogenisierung des Temperaturfelds (T) ferner ein Gerät (21 a, 21 b) zur Erzeugung magnetischer Felder umfasst.

10. Die Anordnung (1) gemäß Anspruch 9, bei der
die Tiegel (14) kreisförmig innerhalb des Ofens (10) angeordnet sind und ein weiterer Tiegel (14b) in der Mitte des Kreises von Tiegeln (14) angeordnet ist und das Gerät zur Erzeugung magnetischer Felder innerhalb des die Tiegel (14) gemeinsam umschließenden, gas-, vakuum- und/oder druckdichten Kessels (8) angeordnet ist, oder bei der das Gerät (21) zur Erzeugung magnetischer Felder außerhalb der Vielzahl von Tiegeln (14) angeordnet ist und von außen auf diese einwirkt,
oder die Geräte (21 und 21b) gleichzeitig innerhalb und außerhalb angeordnet sind und auf die Tiegel einwirken.

11. Anordnung (1) zur Herstellung eines Kristalls aus der Schmelze (16) eines Rohmaterials, umfassend:

einen Ofen (10) mit einer ein oder mehrere Heizelemente (20, 21) aufweisenden Heizvorrichtung, die zur Erzeugung eines in einer ersten Richtung (18) gerichteten Temperaturfeldes (T) in dem Ofen (10) eingerichtet ist, eine Vielzahl von wenigstens zwei Tiegeln (14) zur Aufnahme der Schmelze (16), die nebeneinander in dem gerichteten Temperaturfeld (T) angeordnet sind, und
eine Einrichtung (21 a, 21 b, 24, 26) zur Homogenisierung des Temperaturfelds (T) in einer Ebene senkrecht zu der ersten Richtung (18) in den wenigstens zwei Tiegeln (14),
wobei die Einrichtung zur Homogenisierung des Temperaturfelds umfasst:

- ein Füllmaterial (24), das in einem Zwischenraum (23) zwischen den Tiegeln (14) angeordnet ist, und
- ein Gerät (21a, 21b) zur Erzeugung magnetischer Felder, das eingerichtet ist, einer asymmetrischen Ausbildung einer Phasengrenze beim Erstarren der Schmelze (16) aufgrund der gegenseitigen Beeinflussung der Vielzahl von Tiegeln (14) entgegenzuwirken.

12. Die Anordnung (1) gemäß einem der Ansprüche 1 bis 11, wobei
die Anordnung zur Herstellung von Einkristallen der Verbindungshalbleiter der Gruppen II-VI, IV-IV und III-V, insbesondere GaAs, CdTe oder InP, oder von Ge oder Si eingerichtet ist, oder
die Anordnung zur Herstellung von polykristallinem Material mit quadratischen bzw. rechteckigen Querschnittsgrößen von mindestens 100 x 100 mm bzw. 125x125 mm oder 150x150 mm eingerichtet ist, oder
die Anordnung zur Herstellung von Einkristallen mit einem Durchmesser von 3", 4", 6" oder 8" oder von dazwischen liegenden Werten eingerichtet ist.

13. Die Anordnung (1) gemäß einem der Ansprüche 1 bis 12, wobei
die Heizvorrichtung einen Bodenheizer (20b) und einen Deckelheizer (20a) als Heizelemente (20) umfasst.

14. Die Anordnung (1) gemäß einem der Ansprüche 1 bis 13, wobei die Heizvorrichtung einen oder mehrere Mantelheizer (21) als Heizelemente umfasst.

15. Verwendung der Anordnung (1) gemäß einem der Ansprüche 1 bis 14 zur Herstellung eines Kristalls aus der Schmelze (16) eines Rohmaterials.

16. Verfahren zur Herstellung eines Kristalls aus der Schmelze (16) eines Rohmaterials, umfassend:

Einbringen einer Rohschmelze (16) in eine Vielzahl von in einem Ofen (10) nebeneinander angeordneten Tiegeln (14);
Erzeugen eines gerichteten Temperaturfelds (T) in jedem der Tiegel (14) in einer ersten Richtung (18);
Homogenisieren des Temperaturfelds (T) in einer Ebene senkrecht zu der ersten Richtung (18)

(a) anhand eines Füllmaterials, das in einen Zwischenraum zwischen die Tiegel (14) eingebracht wird, und/oder
(b) durch Erzeugen von magnetischen Wanderfeldern, die auf die Rohschmelze (16) in dem Ofen (10) einwirken;

gerichtetes Erstarren der Rohschmelze (16) zur Bildung des Kristalls.

## Claims

1. Arrangement (1) for manufacturing a crystal from a melt (16) of a raw material, comprising:

a furnace (10) including a heating device having one or more heating elements (20,21), which are configured to generate a gradient temperature field (T) in the furnace (10) which is oriented in a first direction (18),
a plurality of at least two crucibles (14) for receiving the melt (16), which are arranged in the gradient temperature field (T) side by side, and
a device (21a, 21b, 46, 26) for homogenizing the temperature field (T) within a plane perpendicular to the first direction (18) within the at least two crucibles (14),
wherein device for homogenizing the temperature field comprises a filling material (24), which is arranged within a space (23) between the crucibles (14),
wherein the filling material (24) effects an anisotropic heat conduction, wherein
a first component of the heat conduction in the first direction (18) is smaller than a second component of the heat conduction along the plane perpendicular to the first direction (18), in order to allow a fast temperature compensation between the crucibles within this plane.

2. The arrangement (1) according to claim 1, wherein
the crucibles are each arranged within a gas-, vacuum- and/or pressure-tight ampoule (9), and the filling material (24) is inserted between the gas-, vacuum- and/or pressure-tight ampoules (9) and externally from the ampoules (9), or
the crucibles (14) are connectively arranged within one gas-, vacuum- and/or pressure-tight vessel (8), and the filling material (24) is arranged within the vessel (8) between the crucibles (14).

3. The arrangement (1) according to claim 1 or 2, wherein
the filling material (24) has a heat conductivity coefficient, which is adapted to the material of the melt.

4. The arrangement (1) according to one of claims 1 through 3, wherein

the filling material (24) comprises a material of the group comprising: graphite, ceramics or fiber material, or comprises the material of the raw melt (16), wherein the material of the filling material comprising the material of the raw melt (16) is filled in interstitial crucibles (26),

wherein the external shape is adapted to that of the plurality of crucibles (14), in order to fill out the space (23) between the crucibles (14) or in the case of the gas-, vacuum- and/or pressure-tight ampoules (9) fills out the space (23) between ampoules (9) containing the crucibles (14).

5. The arrangement (1) according to claim 1 or 2, wherein
a first component of heat conductivity in the first direction (18) is smaller than the heat conductivity of the material of the raw melt (16) contained in the crucibles (14), or
a second component of the heat conductivity within a plane perpendicular to the first direction (18) is larger than or equal to the heat conductivity of the material of the raw melt contained in the crucibles (14), in order to enable a fast temperature compensation between the crucibles within this claim.

6. The arrangement (1) according to one of claims 1 through 3, wherein the filling material (24) is a fibre material or a laminated composite material.

7. The arrangement (1) according to one of claims 1 through 3, wherein
the filling material comprises a number of separately provided filling bodies having partially different material properties, and which are insertable into the spaces between the crucibles of the arrangement independently from each other, and
for at least two of the filling bodies different material properties are provided with respect to the heat conductivity, wherein the characteristics of the filling material (24) in the centre of the arrangement are different from those in the peripheral areas.

8. The arrangement (1) according to one of claims through 3, wherein
the crucibles (14) are arranged symmetrically in an azimuthal direction around a common centre point in one or more circle(s), or
the crucibles (14) are placed in a hexagonal arrangement within the furnace (10), or
the crucibles (14a) comprise a rectangular shape in a transverse direction along the plane perpendicular to the first direction (18) and are arranged matrix-like in rows and columns with each at least two crucibles (14a).

9. The arrangement (1) according to one of the preceding claims, wherein the device for homogenizing the temperature field (T) further comprises a device (21a, 21 b) for generating magnetic fields.

10. The arrangement (1) according to claim 9, wherein
the crucibles (14) are arranged in circular form within the furnace (10) and wherein a further crucible (14b) is arranged in the centre of the circle of crucibles (14), and the device for generating magnetic fields is arranged within the gas-, vaccum- and/or pressure-tight vessel (8) enclosing the crucibles (14), or wherein
the device (21) for generating magnetic fields is arranged externally from the plurality of crucibles (14) and acts upon these from external, or
the devices (21 and 21b) are simultaneously arranged internally and externally and act on the crucibles.

11. Arrangement (1) for manufacturing a crystal from a melt (16) of a raw material, comprising:

a furnace (10) including a heating device having one or more heating elements (20, 21), which are configured to gene-rate a gradient temperature field (T) in the furnace (10) which is oriented in a first direction (18),
a plurality of at least two crucibles (14) for receiving the melt (16), which are arranged in the gradient temperature field (T) side by side, and
a device (21a, 21 b, 24, 26) for homogenizing the temperature field (T) within a plane perpendicular to the first direction (18) within the at least two crucibles (14),
wherein the device for homogenizing the temperature field comprises:

- a filling material (24) arranged within a space (23) between the crucibles (14), and
- a device (21 a, 21 b) for generating magnetic fields, which is configured to act against an asymmetric development of a phase transition upon freezing the melt (16) due to the mutual influence between the plurality of crucibles (14).

**12.** The arrangement (1) according to one of claims 1 through 11, wherein
the arrangement is configured to manufacture single crystals of compound semiconductors of groups II-VI, IV-IV and III-V, in particular GaAs, CdTe or InP, or of Ge or Si, or
the arrangement is configured to manufacture polycrystalline material having square or rectangular cross-sectional shapes of at least 100 x 100 mm or 125 x 125 mm or 150x150mm,or
the arrangement is configured to manufacture single crystals having a diameter of 3", 4", 6" or 8" or of diameters ranging between the given values.

**13.** The arrangement (1) according to one of claims 1 through 12, wherein
the heating device comprises a bottom heater (20b) and a top heater (20a) as heating elements (20).

**14.** The arrangement (1) according to one of claims 1 through 13, wherein the heating device comprises one or more jacket heaters (21) as heating elements.

**15.** Use of the arrangement (1) according to one of claims 1 through 14 for manufacturing a crystal of a melt (16) of a raw material.

**16.** Method for manufacturing a crystal from a melt (16) of a raw material, comprising:

inserting a raw melt (16) into a plurality of crucibles (14) arranged within a furnace (10) side by side;
generating a gradient temperature field (T) in each of the crucibles (14) in a first direction (18);
homogenizing the temperature field (G) within a plane perpendicular to the first direction (18)

(a) by means of a filling material, that is inserted into a space between the crucibles (14), and/or
(b) by generating magnetic migration fields, which act on the raw melt (16) within the furnace (10);

directed freezing of the raw melt (16) to form the crystal.

**Revendications**

**1.** Installation (1) pour la fabrication d'un cristal à partir de la masse en fusion (16) d'une matière première, comprenant :

un four (10) avec un dispositif de chauffage comportant un ou plusieurs éléments chauffants (20, 21), prévu pour générer dans le four (10) un champ de température (T) orienté dans une première direction (18),
une pluralité de creusets, comportant au moins deux creusets (14) pour contenir la masse en fusion (16), disposés côte à côte dans le champ de température (T) orienté, et
un dispositif (21a, 21 b, 46, 26) destiné à homogénéiser le champ de température (T) sur un plan perpendiculaire à la première direction (18) dans les au moins deux creusets (14),
le dispositif d'homogénéisation du champ de température comprenant une matière de charge (24) disposée dans un interstice (23) entre les creusets (14),
la matière de charge (24) générant une conduction thermique anisotrope,
une première composante de la conduction thermique dans la première direction (18) étant inférieure à une deuxième composante de la conduction thermique de la matière le long du plan perpendiculaire à la première direction (18), pour permettre un équilibrage thermique rapide entre les creusets sur ce plan.

**2.** Installation (1) selon la revendication 1, dans laquelle
les creusets sont disposés chacun dans un conteneur (9) étanche aux gaz, au vide et/ou à la pression, et la matière de charge (24) étant introduite entre les conteneurs (9) étanches aux gaz, au vide et/ou à la pression et à l'extérieur desdits conteneur (9), ou
les creusets (14) étant disposés ensemble à l'intérieur d'une cuve (8) étanche aux gaz, au vide et/ou à la pression, et la matière de charge (24) étant disposée entre les creusets (14) à l'intérieur de la cuve (8).

**3.** Installation (1) selon la revendication 1 ou 2, dans laquelle
la matière de charge (24) présente un coefficient de conduction thermique adapté au matériau de la fonte brute.

**4.** Installation (1) selon l'une des revendications 1 à 3, dans laquelle
la matière de charge (24) est une matière du groupe comprenant : graphite, céramique ou matériau à base de fibres, ou

comprend le matériau de la fonte brute (16), la matière de charge comprenant le matériau de la fonte brute (16) étant introduite dans des creusets intermédiaires (26) dont la forme extérieure est ajustée à celle de la pluralité de creusets (14), pour combler l'interstice (23) entre les creusets (14), ou entre les conteneurs (9) contenant les creusets (14) en cas de conteneurs (9) étanches aux gaz, au vide et/ou à la pression.

5. Installation (1) selon la revendication 1 ou 2, dans laquelle
une première composante de la conduction thermique dans la première direction (18) est inférieure à la conduction thermique du matériau de la fonte brute (16) à recevoir par les creusets (14), ou
une deuxième composante de la conduction thermique est supérieure ou égale à la conduction thermique du matériau de la fonte brute à recevoir par les creusets (14) sur le plan perpendiculaire à la première direction (18), pour permettre un équilibrage thermique rapide entre les creusets sur ce plan.

6. Installation (1) selon l'une des revendications 1 à 3, dans laquelle la matière de charge (24) est un matériau à base de fibres ou un matériau composite lamellé.

7. Installation (1) selon l'une des revendications 1 à 3, dans laquelle
la matière de charge comprend un certain nombre de corps de charge se présentant séparés les uns des autres, pouvant être mis en place indépendamment les uns des autres dans les interstices entre les creusets de l'installation, et dans laquelle
des qualités de matériau différentes en termes de conduction thermique sont prévues pour au moins deux des corps de charge, les propriétés de la matière de charge (24) au centre de l'installation étant différentes de celles des zones de bord.

8. Installation (1) selon l'une des revendications 1 à 3, dans laquelle
les creusets (14) sont disposés symétriquement en direction azimutale tout autour d'un centre commun en formant un ou plusieurs cercles autour du centre commun, ou
les creusets (14) sont placés suivant un agencement hexagonal à l'intérieur du four (10), ou
les creusets (14a) présentent chacun une section transversale de forme rectangulaire sur le plan perpendiculaire à la première direction (18), et sont disposés en formant une matrice de rangées et de colonnes d'au moins deux creusets (14a) chacune.

9. Installation (1) selon l'une des revendications précédentes, dans laquelle le dispositif d'homogénéisation du champ de température (T) comprend en outre un appareil (21a, 21b) pour la génération de champs magnétiques.

10. Installation (1) selon la revendication 9, dans laquelle
les creusets (14) sont disposés en cercle à l'intérieur du four (10) et un autre creuset (14b) est disposé au centre du cercle de creusets (14), et l'appareil de génération des champs magnétiques est disposé à l'intérieur de la cuve (8) étanche aux gaz, au vide et/ou à la pression englobant la totalité des creusets (14), ou dans laquelle
l'appareil (21) de génération des champs magnétiques est disposé à l'extérieur de la pluralité de creusets (14) et agit sur ceux-ci depuis l'extérieur, ou
les appareils (21 et 21 b) sont disposés à la fois à l'intérieur et à l'extérieur et agissent sur les creusets.

11. Installation (1) pour la fabrication d'un cristal à partir de la masse en fusion (16) d'une matière première, comprenant :

un four (10) avec un dispositif de chauffage comportant un ou plusieurs éléments chauffants (20, 21), prévu pour générer dans le four (10) un champ de température (T) orienté dans une première direction (18),
une pluralité de creusets, comportant au moins deux creusets (14) pour contenir la masse en fusion (16), disposés côte à côte dans le champ de température (T) orienté, et
un dispositif (21 a, 21 b, 46, 26) destiné à homogénéiser le champ de température (T) sur un plan perpendiculaire à la première direction (18) dans les au moins deux creusets (14),
le dispositif d'homogénéisation du champ de température comprenant :

- une matière de charge (24) disposée dans un interstice (23) entre les creusets (14), et
- un appareil (21 a, 21 b) destiné à générer des champs magnétiques, prévu pour prévenir une formation asymétrique d'une limite de phase lors du durcissement de la masse en fusion (16) sur la base de l'influence réciproque de la pluralité de creusets (14).

**12.** Installation (1) selon l'une des revendications 1 à 11, dans laquelle

l'installation est prévue pour la fabrication de monocristaux des semiconducteurs alliés des groupes II-VI, IV-IV et III-V, en particulier GaAs, CdTe ou InP, ou de Ge ou Si, ou

l'installation est prévue pour la fabrication d'un matériau polycristallin à grandeur de section transversale carrée ou rectangulaire au moins égale à 100 x 100 mm ou 125x125 mm ou 150x150 mm, ou

l'installation est prévue pour la fabrication de monocristaux avec un diamètre de 3", 4", 6" ou 8", ou de valeur comprise entre celles-ci.

**13.** Installation (1) selon l'une des revendications 1 à 12, dans laquelle

le dispositif de chauffage comprend un élément chauffant de base (20b) et un élément chauffant de sommet (20a) en tant qu'éléments chauffants (20).

**14.** Installation (1) selon l'une des revendications 1 à 13, dans laquelle le dispositif de chauffage comprend un ou plusieurs éléments chauffants enveloppants (21) en tant qu'éléments chauffants.

**15.** Utilisation de l'installation (1) selon l'une des revendications 1 à 14 pour la fabrication d'un cristal à partir de la masse en fusion (16) d'une matière première.

**16.** Procédé de fabrication d'un cristal à partir de la masse en fusion (16) d'une matière première, comprenant les étapes suivantes :

introduction d'une fonte brute (16) dans une pluralité de creusets (14) disposés côte à côte dans un four (10) ;
génération d'un champ de température (T) orienté dans chacun des creusets (14) dans une première direction (18) ;
homogénéisation du champ de température (T) sur un plan perpendiculaire à la première direction (18)

(a) au moyen d'une matière de charge introduite dans un interstice entre les creusets (14), et/ou
(b) par génération de champs magnétiques progressifs agissant sur la fonte brute (16) dans le four (10) ;

durcissement orienté de la fonte brute (16) pour former le cristal.

Fig. 1

Fig. 2

Fig. 3

Fig. 4

Fig. 5

Fig. 6

Fig. 7

Fig. 8

Fig. 9

12   10   1

18

18

18   185   16

14   16

14b

18

18   14

18

16   14

Fig. 10

Fig. 11

1

20a

21b

35

16a

21a ; 21

33    33

14    16b

21 ; 21a

20b

14

14    14

14

16

21b

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3796552 A
- EP 0130865 A1
- EP 1147248 A
- US 6712904 B
- WO 2005041278 A2

**In der Beschreibung aufgeführte Nicht-Patentliteratur**

- **WILKE, K.-TH. ; J. BOHM.** Kristallzüchtung. Verlag der Wissenschaften, 1973, 1-922
- **A.G. FISCHER.** *J. of Electr. Chem. Society,* 1970, vol. 20 (4
- **S.E. BLUM et al.** *Brief Communications of the Electr. Chem. Society,* 1972, vol. 20 (4
- **JANTZ, W. ; STIBAL, R.** Contactless resistivity mapping of semi-insulating substrates. *III-Vs Review,* 1993, vol. 6 (4), 38-39
- **STIBAL, R. ; WICKERT, M. ; HIESINGER, P. ; JANTZ, W.** Contactless mapping of mesoscopic resistivity variations in semi-insulating substrates. *Materials Science and Engineering B,* 1999, vol. 66 (1-3), 21-25
- **WICKERT, M. et al.** High Resolution EL2 and Resistivity Topography of SI GaAs Wafers. IEEE Inc, 1998, vol. 21-24
- **WICKERT, M. et al.** Comparative High Resolution EL2 and Resistivity Topography of Semi-Insulating GaAs Wafers. IEEE Inc, 01. Juni 1998
- **H.D. GEILER et al.** Photoelastic characterization of residual stress in GaAs-Wafers. *Materials and Science in Semiconductor Processing,* 2006, vol. 9, 345-350